# EUROPEAN PATENT APPLICATION

(11) **EP 4 553 890 A1**
(43) Date of publication of application: **14.05.2025**
(21) Application number: 23846297.2
(22) Date of filing: 18.07.2023
(51) Int. Cl.: H01L 21/301, H01L 21/304

(54) **FILM FOR TEMPORARY FIXING, LAMINATE FOR TEMPORARY FIXING, METHOD FOR MANUFACTURING SEMICONDUCTOR DEVICE, COMPOSITION FOR TEMPORARY FIXING**

(30) Priority: 25.07.2022 JP 2022118005
(71) Applicant: Resonac Corporation, Tokyo 105-7325 (JP)
(72) Inventor: MIYAZAWA, Emi, Minato-ku, Tokyo 105-7325 (JP); AKASU, Yuta, Minato-ku, Tokyo 105-7325 (JP); ENOMOTO, Tetsuya, Minato-ku, Tokyo 105-7325 (JP)
(74) Representative: Hoffmann Eitle
(86) International application number: PCT/JP2023/026237
(87) International publication number: WO 2024/024566

(57) **Abstract**

A film for temporary fixing used for temporarily fixing a semiconductor member and a support member is disclosed. The film for temporary fixing contains: an ultraviolet absorber having a hydroxyl group; a thermosetting resin having a functional group capable of reacting with a hydroxyl group; and a thermoplastic resin.

## Description

### Technical Field

The present disclosure relates to a film for temporary fixing, a laminated body for temporary fixing, a method for manufacturing a semiconductor device, and a composition for temporary fixing.

### Background Art

In the manufacture of semiconductor elements, there are occasions in which an integrated circuit is incorporated into a semiconductor substrate such as a semiconductor wafer or a semiconductor chip, and then a semiconductor member having the semiconductor substrate is processed. The semiconductor member is subjected to, for example, processing treatments such as grinding of the back surface and singulation by dicing. The semiconductor member is usually processed in a state of being temporarily fixed to a support member, and then the semiconductor member is separated from the support member. For example, Patent Literature 1 discloses a method of separating a semiconductor member from a support member by irradiating a temporary fixing material layer with ultraviolet light (ultraviolet laser light).

### Citation List

### Patent Literature

Patent Literature 1: JP 2013-033814 A

### Summary of Invention

### Technical Problem

An object of the present disclosure is to provide a film for temporary fixing capable of forming a temporary fixing material layer that can separate a semiconductor member and a support member when irradiated with light including ultraviolet light.

### Solution to Problem

The present disclosure provides a film for temporary fixing according to [1] to [4], a laminated body for temporary fixing according to [5] to [8], a method for manufacturing a semiconductor device according to [9], and a composition for temporary fixing according to [10] to [12].
[1] A film for temporary fixing, used for temporarily fixing a semiconductor member and a support member, the film for temporary fixing containing:
   an ultraviolet absorber having a hydroxyl group;
   a thermosetting resin having a functional group capable of reacting with the hydroxyl group; and
   a thermoplastic resin.
[2] The film for temporary fixing according to [1], wherein the thermosetting resin is an epoxy resin.
[3] The film for temporary fixing according to [1] or [2], wherein the thermoplastic resin is a hydrocarbon resin.
[4] The film for temporary fixing according to any of [1] to [3], wherein a transmittance at at least one wavelength between a wavelength of 308 nm and a wavelength of 355 nm is 15% or less.
[5] A laminated body for temporary fixing, including:
   a support member; and
   a temporary fixing material layer provided on the support member and formed from the film for temporary fixing according to [1].
[6] The laminated body for temporary fixing according to [5], further including a curable resin layer provided on the temporary fixing material layer.
[7] A laminated body for temporary fixing, including, in the following order:
   a support member;
   a first curable resin layer; and
   a temporary fixing material layer formed from the film for temporary fixing according to [1].
[8] The laminated body for temporary fixing according to [7], further including a second curable resin layer provided on the temporary fixing material layer.
[9] A method for manufacturing a semiconductor device, the method including:
   preparing the laminated body for temporary fixing according to any of [5] to [8];
   temporarily fixing a semiconductor member to the support member, with the temporary fixing material layer interposed therebetween;
   processing the semiconductor member temporarily fixed to the support member; and
   irradiating the temporary fixing material layer of the laminated body for temporary fixing with ultraviolet light from the support member side, to separate the semiconductor member from the support member.
[10] A composition for temporary fixing, used for temporarily fixing a semiconductor member and a support member, the composition for temporary fixing containing:
   an ultraviolet absorber having a hydroxyl group;
   a thermosetting resin having a functional group capable of reacting with the hydroxyl group; and
   a thermoplastic resin.
[11] The composition for temporary fixing according to [10], wherein the thermosetting resin is an epoxy resin.
[12] The composition for temporary fixing according to [10] or [11], wherein the thermoplastic resin is a hydrocarbon resin.

According to the above-described film for temporary fixing, a semiconductor member and a support member can be separated by irradiation of light including ultraviolet light, and it is suitable for forming a temporary fixing material layer. The reason why a semiconductor member and a support member can be separated by irradiation with light including ultraviolet light by using such a film for temporary fixing, is not clearly understood; however, the inventors of the present invention speculate, for example, as follows. First, when the film for temporary fixing is treated by heating or the like, the ultraviolet absorber having a hydroxyl group reacts with the thermosetting resin having a functional group capable of reacting with a hydroxyl group to form a cured product that includes a high-molecular weight component while incorporating an ultraviolet absorber. Next, when irradiated with light including ultraviolet light, the ultraviolet absorber absorbs these light energies, molecular weight reduction of a high-molecular weight component (melting of a cured product) proceeds as a result of, for example, cutting of the molecular chain of the high-molecular weight component by thermal energy, and it is presumed that the semiconductor member and the support member can be separated.

### Advantageous Effects of Invention

According to the present disclosure, a film for temporary fixing capable of forming a temporary fixing material layer that can separate a semiconductor member and a support member when irradiated with light including ultraviolet light, is provided. Furthermore, according to the present disclosure, a laminated body for temporary fixing and a method for manufacturing a semiconductor device, which use such a film for temporary fixing, are provided. In addition, according to the present disclosure, a composition for temporary fixing useful for forming a film for temporary fixing is provided.

### Brief Description of Drawings

[FIG. 1] FIG. 1 is a schematic cross-sectional view illustrating an embodiment of a film for temporary fixing.
[FIG. 2] FIG. 2A, FIG. 2B, and FIG. 2C are schematic cross-sectional views illustrating an embodiment of a laminated body for temporary fixing.
[FIG. 3] FIG. 3A and FIG. 3B are schematic cross-sectional views illustrating an embodiment of a method for manufacturing a semiconductor device.
[FIG. 4] FIG. 4A, FIG. 4B, and FIG. 4C are schematic cross-sectional views illustrating an embodiment of the method for manufacturing a semiconductor device.
[FIG. 5] FIG. 5A and FIG. 5B are schematic cross-sectional views illustrating an embodiment of the method for manufacturing a semiconductor device.

### Description of Embodiments

Hereinafter, embodiments of the present disclosure will be described with appropriate reference to the drawings. However, the present disclosure is not intended to be limited to the following embodiments. In the following embodiments, the constituent elements thereof (also including steps and the like) are not essential, unless particularly stated otherwise. The sizes of the constituent elements in each drawing are conceptual, and the relative relationships between the sizes of the constituent elements are not limited to those shown in each drawing.

The same also applies to the numerical values and their ranges in the present disclosure, and the present disclosure is not limited thereby. A numerical value range expressed using the term "to" in the present specification indicates a range including the numerical values described before and after the term "to" as the minimum value and the maximum value, respectively. With regard to a numerical value range described stepwise in the present specification, the upper limit value or lower limit value described in one numerical value range may be replaced with the upper limit value or lower limit value of another numerical value range described stepwise. Furthermore, with regard to a numerical value range described in the present specification, the upper limit value or the lower limit value of that numerical value range may be replaced with a value indicated in the Examples.

The term "layer" as used in the present specification encompasses a structure having a shape formed over the entire surface as well as a structure having a shape formed on a portion, when viewed in a plan view. Furthermore, the term "step" as used in the present specification includes not only an independent step, but also a step that achieves a predetermined action even if the step cannot be clearly distinguished from other steps.

In the present specification, the term (meth)acrylate means acrylate or methacrylate corresponding thereto. The same also applies to other similar expressions such as (meth)acryloyl group and (meth)acrylic copolymer.

In the present specification, regarding the materials listed below as examples, unless particularly stated otherwise, one kind thereof may be used alone, or two or more kinds thereof may be used in combination, to the extent that the conditions are met. When there are a plurality of substances corresponding to each component, unless particularly stated otherwise, the content of each component means the total amount of the plurality of substances.

### [Film for Temporary Fixing]

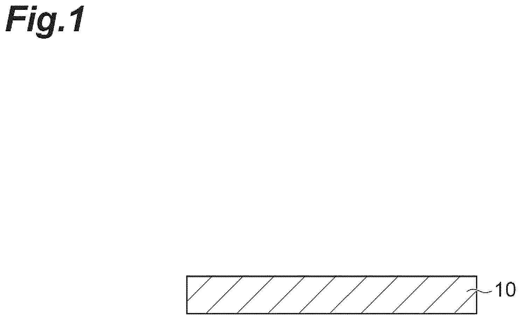

FIG. 1 is a schematic cross-sectional view illustrating an embodiment of a film for temporary fixing. The film for temporary fixing 10 shown in FIG. 1 is used for temporarily fixing a semiconductor member and a support member. More specifically, the film for temporary fixing 10 is used to form a layer for temporarily fixing a semiconductor member (temporary fixing material layer) to a support member while processing the semiconductor member in the manufacture of a semiconductor device. The film for temporary fixing 10 contains an ultraviolet absorber having a hydroxyl group (hereinafter, may be referred to as "component (A)"), a thermosetting resin having a functional group capable of reacting with a hydroxyl group (hereinafter, may be referred to as "component (B)"), and a thermoplastic resin (hereinafter, may be referred to as "component (C)").

### Component (A): Ultraviolet Absorber Having Hydroxyl Group

Component (A) may be a component that absorbs light including ultraviolet light (ultraviolet radiation). The component (A) may also be a component that absorbs light including wavelengths of 200 to 400 nm (near-ultraviolet light). Since the component (A) has a hydroxyl group, there is a tendency that bleed-out from the film for temporary fixing is less likely to occur due to the interaction between the hydroxyl group and the component (B). Furthermore, it is speculated that when the film for temporary fixing is treated by heating or the like, the component (A) and the component (B) react with each other to form a cured product including a high-molecular weight component while incorporating the component (A). Therefore, it can be expected to improve dispersibility of the ultraviolet absorber component in the film for temporary fixing by using the component (A).

Examples of the ultraviolet absorber having a hydroxyl group include triazine-based ultraviolet absorbers having a triazine skeleton, such as 2-(4,6-diphenyl-1,3,5-triazin-2-yl)-5-[2-(2-ethylhexanoyloxy)ethoxy]ph enol, 2,4,6-tris(2-hydroxy-4-hexyloxy-3-methylphenyl)-1,3,5-triazine, 2,4,6-tris(4-butoxy-2-hydroxyphenyl)-1,3,5-triazine, and 2,4-bis(2,4-dimethylphenyl)-6-(2-hydroxy-4-n-octyloxyphenyl)-1,3,5-tri azine; benzotriazole-based ultraviolet absorbers having a benzotriazole skeleton, such as 2-(2H-benzotriazol-2-yl)-4,6-bis(1-methyl-1-phenylethyl)phenol, 2-(2H-benzotriazol-2-yl)-4-(1,1,3,3-tetramethylbutyl)phenol, 2,2'-methylenebis[6-(2H-benzotriazol-2-yl)-4-(1,1,3,3-tetramethylbutyl) phenol], 2-(2H-benzotriazol-2-yl)-p-cresol, and 2-(5-chloro-2H-benzotriazol-2-yl)-6-tertiary butyl-4-methylphenol; and benzophenone-based ultraviolet absorbers having a benzophenone skeleton, such as [2-hydroxy-4-(octyloxy)phenyl](phenyl)methanone. Among these, the component (A) may be a triazine-based ultraviolet absorber or a benzotriazole-based ultraviolet absorber, or may be a triazine-based ultraviolet absorber. The triazine-based ultraviolet absorber may be, for example, 2,4,6-tris(2-hydroxy-4-hexyloxy-3-methylphenyl)-1,3,5-triazine.

The component (A) is not particularly limited; however, it is preferable that the component (A) is added to the film for temporary fixing such that, for example, the transmittance at at least one wavelength between a wavelength of 308 nm and a wavelength of 355 nm becomes 15% or less. The content of the component (A) may be 0.5 to 40 parts by mass with respect to 100 parts by mass of the total amount of the component (B) and the component (C). When the content of the component (A) is 0.5 parts by mass or more with respect to 100 parts by mass of the total amount of the component (B) and the component (C), the semiconductor member and the support member tend to be easily separated by irradiation with light including ultraviolet light, and when the content is 40 parts by mass or less, curing inhibition is less likely to occur, while high heat resistance tends to be maintained. The content of the component (A) may be 1 part by mass or more, 1.5 parts by mass or more, or 2 parts by mass or more, and may be 30 parts by mass or less, 20 parts by mass or less, or 15 parts by mass or less, with respect to 100 parts by mass of the total amount of the component (B) and the component (C).

### Component (B): Thermosetting Resin Having Functional Group Capable of Reacting with Hydroxyl Group

Component (B) means a resin that has a functional group capable of reacting with a hydroxyl group and is cured by heat, and is a concept that does not include the component (C) that will be described below. Examples of the functional group capable of reacting with a hydroxyl group include an epoxy group and an oxetanyl group. Examples of the component (B) include an epoxy resin; an oxetane resin; and an acrylic resin having an epoxy group, an oxetanyl group, or the like. Among these, the component (B) may be an epoxy resin, since it is more excellent in terms of heat resistance, workability, and reliability.

The epoxy resin is not particularly limited as long as it is cured to have a heat resistance effect. Examples of the epoxy resin include a bifunctional epoxy resin such as a bisphenol A type epoxy resin; a novolac type epoxy resin such as a phenol novolac type epoxy resin or a cresol novolac type epoxy resin; and an alicyclic epoxy resin such as a dicyclopentadiene type epoxy resin. Furthermore, the epoxy resin may be, for example, a polyfunctional epoxy resin, a glycidyl amine type epoxy resin, or a heterocyclic ring-containing epoxy resin. Among these, from the viewpoints of heat resistance and weather resistance, the epoxy resin may include an alicyclic epoxy resin.

The epoxy resin as the component (B) may be used alone, or may be used in combination with a curing agent for an epoxy resin (hereinafter, may be referred to as "component (b)"). Examples of the component (b) include an amine, a polyamide, an acid anhydride, polysulfide, boron trifluoride, bisphenols (bisphenol A, bisphenol F, bisphenol S, and the like), and phenol resins (a phenol novolac resin, a bisphenol A novolac resin, a cresol novolac resin, a phenol aralkyl resin, and the like).

The content of the component (B) (in a case where an epoxy resin and a curing agent for an epoxy resin are used in combination, the sum of the epoxy resin and the curing agent for an epoxy resin) may be 10 to 60 parts by mass with respect to 100 parts by mass of the total amount of the component (B) and the component (C). The content of the component (B) may be 15 parts by mass or more or 20 parts by mass or more, and may be 50 parts by mass or less or 40 parts by mass or less, with respect to 100 parts by mass of the total amount of the component (B) and the component (C). When the content of the component (B) is in the above-described range, the thin film formability, flatness, heat resistance, and the like of the temporary fixing material layer tend to be more excellent.

### Component (C): Thermoplastic Resin

Component (C) may be a resin having thermoplastic properties, or a resin that has thermoplastic properties at least in an uncured state and forms a crosslinked structure after being heated. Examples of the component (C) include a hydrocarbon resin, a phenoxy resin, acrylic rubber, polycarbonate, polyphenylene sulfide, polyethersulfone, polyetherimide, polyimide, and a petroleum resin. Among these, the component (C) may be a hydrocarbon resin, a phenoxy resin, or acrylic rubber, or may be a hydrocarbon resin.

A hydrocarbon resin is a resin in which the main skeleton is composed of a hydrocarbon. Examples of such a hydrocarbon resin include an ethylene-propylene copolymer, an ethylene-1-butene copolymer, an ethylene-propylene-1-butene copolymer elastomer, an ethylene-1-hexene copolymer, an ethylene-1-octene copolymer, an ethylene-styrene copolymer, an ethylene-norbornene copolymer, a propylene-1-butene copolymer, an ethylene-propylene-non-conjugated diene copolymer, an ethylene-1-butene-non-conjugated diene copolymer, an ethylene-propylene-1-butene-non-conjugated diene copolymer, polyisoprene, polybutadiene, a styrene-butadiene-styrene block copolymer (SBS), a styrene-isoprene-styrene block copolymer (SIS), a styrene-ethylene-butylene-styrene block copolymer (SEBS), and a styrene-ethylene-propylene-styrene block copolymer (SEPS). These hydrocarbon resins may be subjected to a hydrogenation treatment. Furthermore, these hydrocarbon resins may be carboxy-modified using maleic anhydride or the like. Among these, the hydrocarbon resin may include a hydrocarbon resin including a monomer unit derived from styrene (styrene-based resin), or may include a styrene-ethylene-butylene-styrene block copolymer (SEBS).

The Tg of the component (C) may be -100 to 500°C, -50 to 300°C, or -50 to 50°C. When the Tg of the component (C) is 500°C or lower, flexibility is easily ensured when a film-shaped temporary fixing material is formed, and there is a tendency that low-temperature adhesiveness can be improved. When the Tg of the component (C) is **-100°C** or higher, there is a tendency that deterioration of handleability and peelability caused by flexibility becoming excessively high when a film-shaped temporary fixing material is formed.

The Tg of the component (C) is a mid-point glass transition temperature value obtained by differential scanning calorimetry (DSC). The Tg of the component (C) is specifically a mid-point glass transition temperature obtained by measuring a calorific change under the conditions of a temperature increase rate of 10°C/min and a measurement temperature of -80 to 80°C, and calculating the transition temperature by the method according to JIS K 7121.

The weight average molecular weight (Mw) of the component (C) may be 10000 to 5000000 or 100000 to 2000000. When the weight average molecular weight is 10000 or more, the heat resistance of the temporary fixing material layer to be formed tends to be easily ensured. When the weight average molecular weight is 5000000 or less, a decrease in flow and deterioration of adhesiveness tend to be easily suppressed when a film-shaped temporary fixing material layer or a resin layer is formed. The weight average molecular weight is a polystyrene-equivalent value obtained by gel permeation chromatography (GPC) using a calibration curve based on polystyrene standards.

The content of the component (C) may be 40 to 90 parts by mass with respect to 100 parts by mass of the total amount of the component (B) and the component (C). The content of the component (C) may be 50 parts by mass or more or 60 parts by mass or more, and may be 85 parts by mass or less or 80 parts by mass or less, with respect to 100 parts by mass of the total amount of the component (B) and the component (C). When the content of the component (C) is in the above-described range, the thin film formability and flatness of the temporary fixing material layer tend to be more excellent.

The component (B) and the component (C) may be main components of the film for temporary fixing. The total content of the component (B) and the component (C) may be 60% by mass or more, 70% by mass or more, 80% by mass or more, 85% by mass or more, 90% by mass or more, or 95% by mass or more, based on the total amount of the film for temporary fixing (or the total amount of the composition for temporary fixing).

### Other Components

The film for temporary fixing 10 may further contain a curing accelerator that accelerates a curing reaction of the component (B) such as an epoxy resin; a polymerizable monomer; a polymerization initiator; an insulating filler; a sensitizer; an antioxidant; and the like as other components.

Examples of the curing accelerator include an imidazole derivative, a dicyandiamide derivative, a dicarboxylic acid dihydrazide, triphenylphosphine, tetraphenylphosphonium tetraphenylborate, 2-ethyl-4-methylimidazole tetraphenylborate, and 1,8-diazabicyclo[5,4,0]undecene-7-tetraphenylborate.

The content of the curing accelerator may be 0.01 to 5 parts by mass with respect to 100 parts by mass of the total amount of the component (B). When the content of the curing accelerator is in such a range, the curability and post-curing heat resistance of the component (B) tend to be more excellent. The content of the curing accelerator may be 0.1 parts by mass or more or 0.3 parts by mass or more, and may be 3 parts by mass or less or 1 part by mass or less, with respect to 100 parts by mass of the total amount of the component (B), because it is made easy to adjust the storage modulus.

The polymerizable monomer is not particularly limited as long as it is polymerized by heating or irradiation with ultraviolet light or the like. From the viewpoints of selectivity of the material and easy availability, the polymerizable monomer may be, for example, a compound having a polymerizable functional group such as an ethylenically unsaturated group. Examples of the polymerizable monomer include a (meth)acrylate, a halogenated vinylidene, a vinyl ether, a vinyl ester, vinylpyridine, vinylamide, and an arylated vinyl. Among these, the polymerizable monomer may be a (meth)acrylate. The (meth)acrylate may be any of monofunctional (unifunctional), bifunctional, or trifunctional or higher-functional compounds; however, from the viewpoint of obtaining sufficient curability, the (meth)acrylate may be bifunctional or higher-functional (meth)acrylate.

The content of the polymerizable monomer may be, for example, 0 to 50 parts by mass based on the total amount of the film for temporary fixing (or the total amount of the composition for temporary fixing).

The polymerization initiator is not particularly limited as long as it initiates polymerization by heating or irradiation with ultraviolet light or the like. For example, in a case where a compound having an ethylenically unsaturated group is used as the polymerizable monomer, the polymerizable initiator may be a thermal radical polymerization initiator or a photoradical polymerization initiator.

The content of the polymerization initiator may be 0.01 to 5 parts by mass with respect to 100 parts by mass of the total amount of the polymerizable monomer.

The insulating filler may be added for the purpose of imparting low thermal expansion properties and low moisture absorption properties to the resin layer. Examples of the insulating filler include non-metal inorganic fillers such as silica, alumina, boron nitride, titania, glass, and ceramics. From the viewpoint of dispersibility in a solvent, the insulating filler may be particles having the surface treated with a surface treatment agent. The surface treatment agent may be, for example, a silane coupling agent.

The content of the insulating filler may be 0.1 to 20 parts by mass with respect to 100 parts by mass of the total amount of the component (B) and the component (C). When the content of the insulating filler is within the above-described range, there is a tendency that heat resistance can be further improved without interfering with light transmission. Furthermore, when the content of the insulating filler is within the above-described range, there is a possibility of contributing to light peelability as well.

Examples of the sensitizer include anthracene, phenanthrene, chrysene, benzopyrene, fluoranthene, rubrene, pyrene, xanthone, indanthrene, thioxanthen-9-one, 2-isopropyl-9H-thioxanthen-9-one, 4-isopropyl-9H-thioxanthen-9-one, and 1-chloro-4-propoxythioxanthone.

The content of the sensitizer may be 0.01 to 10 parts by mass with respect to 100 parts by mass of the total amount of the component (B) and the component (C). When the content of the sensitizer is within the above-described range, there tends to be little influence on the characteristics of the component (B) and thin film properties.

Examples of the antioxidant include quinone derivatives such as benzoquinone and hydroquinone; phenol derivatives (hindered phenol derivatives) such as 4-methoxyphenol and 4-t-butylcatechol; aminoxyl derivatives such as 2,2,6,6-tetramethylpiperidin-1-oxyl and 4-hydroxy-2,2,6,6-tetramethylpiperidin-1-oxyl; and hindered amine derivatives such as tetramethylpiperidyl methacrylate.

The content of the antioxidant may be 0.1 to 10 parts by mass with respect to 100 parts by mass of the total amount of the component (B) and the component (C). When the content of the antioxidant is within the above-described range, there is a tendency that decomposition of the component (B) is suppressed, and contamination can be prevented.

From the viewpoint of stress relaxation, the thickness of the film for temporary fixing 10 may be, for example, 0.1 µm or more, 1 µm or more, or 5 µm or more and may be 200 µm or less, 100 µm or less, or 50 µm or less.

With regard to the film for temporary fixing 10, the transmittance at at least one wavelength between a wavelength of 308 nm and a wavelength of 355 nm may be 15% or less. It is preferable that the film for temporary fixing 10 has a transmittance of 15% or less for light having a wavelength of 355 nm. A film for temporary fixing having low transmissibility for light having either a wavelength of 308 nm or a wavelength of 355 nm efficiently absorbs light including ultraviolet light, and therefore, a semiconductor member and a support member can be separated by irradiation with the light. The transmittance for light having a wavelength of 308 nm may be 12% or less, 10% or less, 8% or less, 5% or less, or 3% or less. The transmittance for light having a wavelength of 355 nm may be 12% or less, 10% or less, 8% or less, 5% or less, or 3% or less. This transmittance tends to be easily adjusted to a predetermined range (15% or less) because the transmittance for light having a predetermined wavelength (a wavelength of 308 nm or a wavelength of 355 nm) can be decreased by increasing the thickness of the film for temporary fixing 10, increasing the content of the component (A) in the film for temporary fixing 10, or the like. In the present specification, the transmittance for light having a wavelength of 308 nm or a wavelength of 355 nm means the proportion of the intensity of transmitted light with respect to the intensity of incident light when light having a predetermined wavelength (light having a wavelength of 308 nm or a wavelength of 355 nm as a main wavelength) is incident on one principal surface side of the film for temporary fixing 10.

According to such a film for temporary fixing 10, it is possible to form a temporary fixing material layer that can separate a semiconductor member and a support member by irradiation with light including ultraviolet light.

### [Method for Manufacturing Film for Temporary Fixing]

With regard to the film for temporary fixing 10, for example, first, a component (A), a component (B), a component (C), and other components as necessary are subjected to stirred mixing, kneading, or the like in a solvent to be dissolved or dispersed therein, and a varnish of a composition for temporary fixing is prepared. Thereafter, a film for temporary fixing 10 formed from a composition for temporary fixing can be formed on a support film by applying the varnish of the composition for temporary fixing on a support film that has been subjected to a mold release treatment, using a knife coater, a roll coater, an applicator, a comma coater, a die coater, or the like, and then volatilizing the solvent by heating. The film for temporary fixing 10 may include a protective film laminated on the surface on the opposite side of the support film. The thickness of the film for temporary fixing 10 can be adjusted by adjusting the coating amount of the varnish of the composition for temporary fixing.

The solvent used for the preparation of a varnish of a composition for temporary fixing is not particularly limited as long as it has characteristics capable of uniformly dissolving or dispersing each component. Examples of such a solvent include aromatic hydrocarbons such as toluene, xylene, mesitylene, cumene, and p-cymene; aliphatic hydrocarbons such as hexane and heptane; cyclic alkanes such as methylcyclohexane; cyclic ethers such as tetrahydrofuran and 1,4-dioxane; ketones such as acetone, methyl ethyl ketone, methyl isobutyl ketone, cyclohexanone, and 4-hydroxy-4-methyl-2-pentanone; esters such as methyl acetate, ethyl acetate, butyl acetate, methyl lactate, ethyl lactate, and γ-butyrolactone; carbonic acid esters such as ethylene carbonate and propylene carbonate; and amides such as N,N-dimethylformamide, N,N-dimethylacetamide, and N-methyl-2-pyrrolidone. Among these, from the viewpoints of solubility and boiling point, the solvent may be toluene, xylene, heptane, or cyclohexanone. The concentration of solid components in the varnish may be 10 to 80% by mass based on the total mass of the varnish.

The stirring mixing or kneading at the time of preparing the varnish of the composition for temporary fixing can be performed using, for example, a stirrer, a Raikai mixer, a three-roll mill, a ball mill, a bead mill, or a Homodisper.

Examples of the support film include films of polyesters such as polyester terephthalate (PET), polybutylene terephthalate, and polyethylene naphthalate; polyolefins such as polyethylene and polypropylene; polycarbonate, polyamide, polyimide, polyamideimide, polyetherimide, polyether sulfide, polyethersulfone, polyether ketone, polyphenylene ether, polyphenylene sulfide, poly(meth)acrylate, polysulfone, and liquid crystal polymers. These support films may be subjected to a mold release treatment. The thickness of the support film may be, for example, 1 to 250 µm.

The heating conditions at the time of volatilizing the solvent from the varnish of the composition for temporary fixing applied on the support film can be set as appropriate in accordance with the solvent used or the like. The heating conditions may be, for example, a heating temperature of 40 to 120°C and a heating time of 0.1 to 30 minutes.

Examples of the protective film include those listed for the above-mentioned support film. The thickness of the protective film may be, for example, 1 to 250 µm.

### [Laminated Body for Temporary Fixing and Method for Manufacturing the Same]

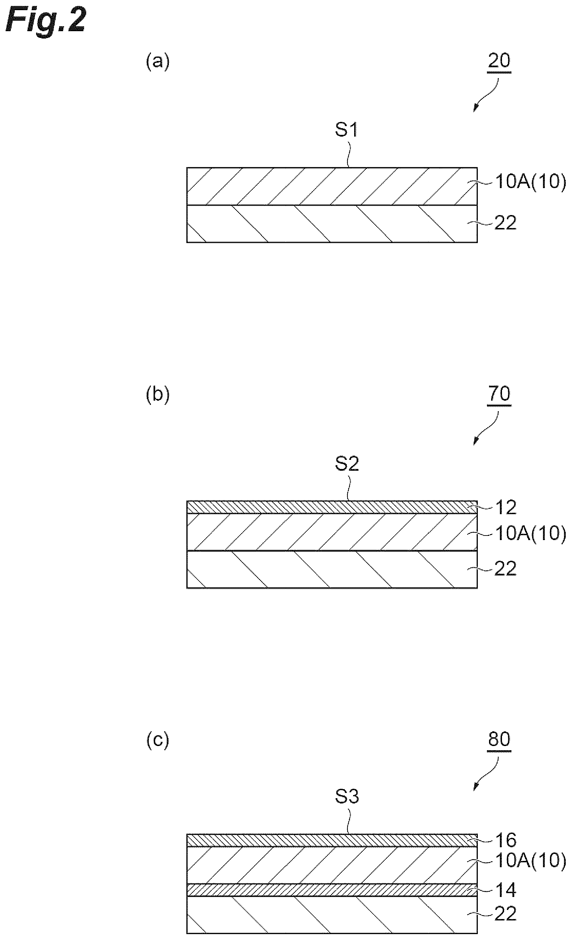

The laminated body for temporary fixing is not particularly limited in terms of the configuration as long as the laminated body includes a support member and a temporary fixing material layer formed from the above-described film for temporary fixing. FIG. 2A, FIG. 2B, and FIG. 2C are schematic cross-sectional views illustrating an embodiment of the laminated body for temporary fixing. Examples of the configuration of the laminated body for temporary fixing include the configuration of a laminated body for temporary fixing 20 shown in FIG. 2A, the configuration of a laminated body for temporary fixing 70 shown in FIG. 2B, and the configuration of a laminated body for temporary fixing 80 shown in FIG. 2C. The laminated body for temporary fixing 20 includes a support member 22; and a temporary fixing material layer 10A provided on the support member 22 and formed from the film for temporary fixing 10. In the laminated body for temporary fixing 20, the temporary fixing material layer 10A has a surface S1 on the opposite side of the support member 22, and a semiconductor member is disposed on the surface S1 of the temporary fixing material layer 10A. The laminated body for temporary fixing 70 includes a support member 22; a temporary fixing material layer 10A formed from the film for temporary fixing 10; and a curable resin layer 12 formed from a curable resin film, in this order. In the laminated body for temporary fixing 70, the curable resin layer 12 has a surface S2 on the opposite side of the temporary fixing material layer 10A, and a semiconductor member is disposed on the surface S2 of the curable resin layer 12. The laminated body for temporary fixing 80 includes a support member 22; a first curable resin layer 14 formed from a first curable resin film; a temporary fixing material layer 10A formed from the film for temporary fixing 10; and a second curable resin layer 16 formed from a second curable resin film, in this order. In the laminated body for temporary fixing 80, the second curable resin layer 16 has a surface S3 on the opposite side of the temporary fixing material layer 10A, and a semiconductor member is disposed on the surface S3 of the second curable resin layer 16. Furthermore, as a configuration of the laminated body for temporary fixing other than these, for example, a configuration including a support member, a curable resin layer (first curable resin layer 14) and a temporary fixing material layer formed from a film for temporary fixing in this order may be mentioned. According to such a laminated body for temporary fixing, since at least the temporary fixing material layer 10A is included, a semiconductor member and a support member can be separated by irradiation with light including ultraviolet light. In the following description, an aspect of using the laminated body for temporary fixing 20 shown in FIG. 2A will be mainly described in detail as an example.

The method for manufacturing the laminated body for temporary fixing 20 is not particularly limited as long as a laminated body for temporary fixing having a predetermined configuration is obtained. The laminated body for temporary fixing 20 can be obtained by, for example, a method including sticking a film for temporary fixing 10 onto a support member 22 to form a temporary fixing material layer 10A.

The support member 22 is a plate-shaped body that has a high transmittance and can withstand the load exerted during the processing of a semiconductor member. Examples of the support member 22 include an inorganic glass substrate and a transparent resin substrate.

The thickness of the support member 22 may be, for example, 0.1 to 2.0 mm. When the thickness of the support member 22 is 0.1 mm or more, handling tends to be made easier. When the thickness of the support member 22 is 2.0 mm or less, there is a tendency that the material cost can be suppressed.

Regarding the method of sticking the film for temporary fixing 10 onto the support member 22, for example, methods such as heat pressing, roll lamination, and vacuum lamination may be mentioned. Lamination can be performed, for example, under the temperature conditions of 0 to 120°C.

The temporary fixing material layer 10A may be a layer formed from the film for temporary fixing 10. From the viewpoint of stress relaxation, the thickness of the temporary fixing material layer 10A may be, for example, 0.1 µm or more, 1 µm or more, or 5 µm or more, and may be 200 µm or less, 100 µm or less, or 50 µm or less.

The laminated body for temporary fixing 70 includes a support member 22, a temporary fixing material layer 10A, and a curable resin layer 12 in this order. By providing the laminated body for temporary fixing 70 with the curable resin layer 12, thermal damage to a semiconductor member tends to be easily suppressed. Furthermore, since burn-in of the resin of the film for temporary fixing and the like onto the semiconductor member can be suppressed, resin residue tends to be easily removed from the semiconductor member. The laminated body for temporary fixing 80 includes a support member 22, a first curable resin layer 14, a temporary fixing material layer 10A, and a second curable resin layer 16 in this order. By providing the laminated body for temporary fixing 80 with the first curable resin layer 14, heat dissipation to the support member is reduced, and there is a tendency that the energy of light irradiation is likely to be efficiently converted to heat. Furthermore, since burn-in of the resin of the film for temporary fixing and the like onto the support member can be suppressed, resin residue tends to be easily removed from the support member.

The curable resin film for forming the curable resin layer 12, the first curable resin film for forming the first curable resin layer 14, and the second curable resin film for forming the second curable resin layer 16 are not particularly limited as long as they are each a resin film exhibiting curability. The curable resin film, the first curable resin film, and the second curable resin film may be films composed of the components excluding the component (A) in the above-described film for temporary fixing 10 (that is, films containing the component (B), the component (C), and other components (provided that the component (A) is excluded)). It is preferable that the curable resin film, the first curable resin film, and the second curable resin film do not contain the component (A). The curable resin film, the first curable resin film, and the second curable resin film may be the same.

Preferred aspects of each of the components (component (B), component (C), other components, and the like) in the curable resin film, the first curable resin film, and the second curable resin film are similar to the preferred aspects of each of the components (component (B), component (C), other components, and the like) in the film for temporary fixing 10. Therefore, any overlapping description will not be repeated herein.

In the curable resin film, the first curable resin film, and the second curable resin film, the content of the component (B) (in a case where an epoxy resin and a curing agent for an epoxy resin are used in combination, the sum of the epoxy resin and the curing agent for an epoxy resin) may be 10 to 90 parts by mass with respect to 100 parts by mass of the total amount of the component (B) and the component (C). The content of the component (B) may be 15 parts by mass or more or 20 parts by mass or more, and may be 80 parts by mass or less, 70 parts by mass or less, 60 parts by mass or less, 50 parts by mass or less, or 40 parts by mass or less, with respect to 100 parts by mass of the total amount of the component (B) and the component (C).

In the curable resin film, the first curable resin film, and the second curable resin film, the content of the component (C) may be 10 to 90 parts by mass with respect to 100 parts by mass of the total amount of the component (B) and the component (C). The content of the component (B) may be 20 parts by mass or more, 30 parts by mass or more, 40 parts by mass or more, 50 parts by mass or more, or 60 parts by mass or more, and may be 85 parts by mass or less or 80 parts by mass or less, with respect to 100 parts by mass of the total amount of the component (B) and the component (C).

The component (B) and the component (C) may be main components of each of the curable resin film, the first curable resin film, and the second curable resin film. The total content of the component (B) and the component (C) may be 60% by mass or more, 70% by mass or more, 80% by mass or more, 85% by mass or more, 90% by mass or more, or 95% by mass or more, based on the total amount of the curable resin film, the total amount of the first curable resin film, or the total amount of the second curable resin film.

In the curable resin film, the first curable resin film, and the second curable resin film, the content of the other components may be similar to the content of the other components in the film for temporary fixing 10.

From the viewpoint of achieving both thermal insulation properties and handleability, the curable resin film and the second curable resin film may be, for example, 0.1 µm or more, 1 µm or more, or 5 µm or more, and may be 200 µm or less, 100 µm or less, or 50 µm or less.

From the viewpoint of achieving both thermal insulation properties and optical transparency, the first curable resin film may be, for example, 0.1 µm or more, 1 µm or more, or 5 µm or more, and may be 200 µm or less, 100 µm or less, or 50 µm or less.

With regard to the first curable resin film, the transmittance at at least one wavelength between a wavelength of 308 nm and a wavelength of 355 nm may be 80% or greater. When the transmittance of the first curable resin film is in such a range, the light irradiated from the support member side to the laminated body for temporary fixing is easily transmitted, and deterioration of separability can be suppressed.

The methods for manufacturing the laminated bodies for temporary fixing 70 and 80 are not particularly limited as long as laminates for temporary fixing having predetermined configurations are obtained. The laminated body for temporary fixing 70 can be obtained by, for example, a method including sticking a film for temporary fixing 10 to a support member 22 to form a temporary fixing material layer 10A; and sticking a curable resin film onto the temporary fixing material layer 10A to form a curable resin layer 12. The laminated body for temporary fixing 80 can be obtained by a method including sticking a first curable resin film onto a support member 22 to form a first curable resin layer 14; sticking a film for temporary fixing 10 onto the first curable resin layer 14 to form a temporary fixing material layer 10A; and sticking a second curable resin film onto the temporary fixing material layer 10A to form a second curable resin layer 16.

### [Method for Manufacturing Semiconductor Device]

A method for manufacturing a semiconductor device according to an embodiment includes: preparing the above-described laminated body for temporary fixing (preparation step); temporarily fixing a semiconductor member to the support member, with a temporary fixing material layer interposed therebetween (temporary fixing step); processing the semiconductor member temporarily fixed to the support member (processing step); and irradiating the temporary fixing material layer of the laminated body for temporary fixing with light including ultraviolet light from the support member side to separate the semiconductor member from the support member (separation step). In the following description, an aspect of using the laminated body for temporary fixing 20 shown in FIG. 2A will be mainly described in detail as an example.

### (Preparation Step)

In the preparation step, in order to manufacture a semiconductor device, a laminated body for temporary fixing 20 for temporarily fixing a semiconductor member to a support member during the processing of the semiconductor member is prepared.

### (Temporary Fixing Step)

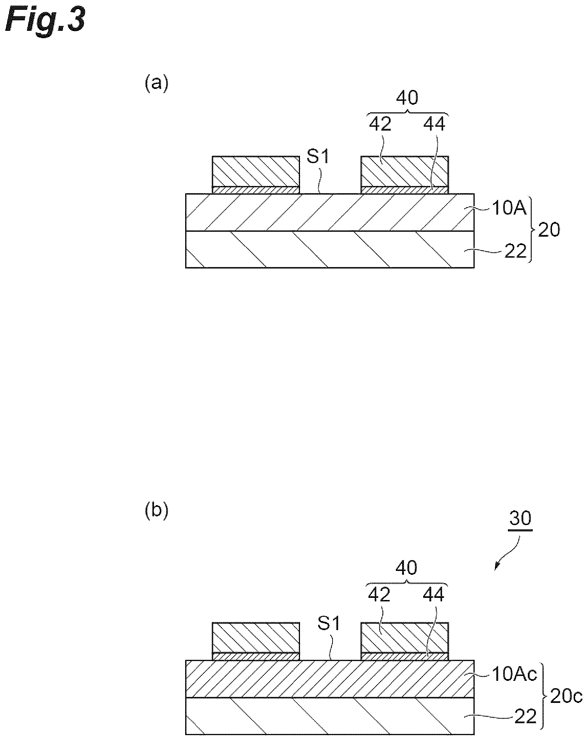

FIG. 3A and FIG. 3B are schematic cross-sectional view illustrating an embodiment of the method for manufacturing a semiconductor device. In the temporary fixing step, a semiconductor member 40 is temporarily fixed to a support member 22, with a temporary fixing material layer 10A interposed therebetween. The temporary fixing material layer 10A has a surface S1 on the opposite side of the support member 22 of the temporary fixing material layer 10A. In the temporary fixing step, for example, the semiconductor member 40 can be temporarily fixed to the support member 22 by curing the temporary fixing material layer 10A (film for temporary fixing 10) in a state in which the semiconductor member 40 is disposed on the temporary fixing material layer 10A (see FIG. 3A) (see FIG. 3B). In other words, the semiconductor member 40 can be temporarily adhered to the support member 22, with a temporary fixing material layer 10Ac formed from a cured product of the film for temporary fixing 10 interposed therebetween. In this way, a laminated body 30 including a laminated body for temporary fixing 20c and a semiconductor member 40 provided on the laminated body for temporary fixing 20c is formed.

The semiconductor member 40 may be a member having a semiconductor substrate 42 such as a semiconductor wafer or a semiconductor chip. The semiconductor member 40 may be, for example, a rewiring layer-attached semiconductor chip having a rewiring layer 44 and a semiconductor substrate 42. In a case where the semiconductor member 40 is a rewiring layer-attached semiconductor chip, the rewiring layer-attached semiconductor chip is temporarily fixed to the support member 22, with the temporary fixing material layer 10A interposed therebetween, in a direction in which the rewiring layer is located on the temporary fixing material layer 10A side. The semiconductor member 40 may further have an external connection terminal. In the example of FIG. 3A, a plurality of semiconductor members 40 are disposed on the temporary fixing material layer 10A; however, the number of the semiconductor members 40 may be one. The thickness of the semiconductor member 40 may be 1 to 1000 µm, 10 to 500 µm, or 20 to 200 µm, from the viewpoint of suppressing cracking during transportation, processing steps, or the like in addition to miniaturization and thickness reduction of semiconductor devices.

The semiconductor member 40 disposed on the temporary fixing material layer 10A is, for example, pressure-bonded to the temporary fixing material layer 10A using a vacuum press machine or a vacuum laminator. In the case of using a vacuum press machine, the conditions for pressure-bonding may be an air pressure of 1 hPa or less, a pressure-bonding pressure of 1 MPa, a pressure-bonding temperature of 120 to 200°C, and a retention time of 100 to 300 seconds. In the case of using a vacuum laminator, the conditions for pressure-bonding may be, for example, an air pressure of 1 hPa or less, a pressure-bonding temperature of 60 to 180°C or 80 to 150°C, a lamination pressure of 0.01 to 1.0 MPa or 0.1 to 0.7 MPa, and a retention time of 1 to 600 seconds or 30 to 300 seconds.

After the semiconductor member 40 is disposed on the temporary fixing material layer 10A, by thermally curing or photocuring the component (B) in the temporary fixing material layer 10A, the semiconductor member 40 is temporarily fixed to the support member 22, with a temporary fixing material layer 10Ac including a cured product of the film for temporary fixing 10 interposed therebetween. The conditions for thermal curing may be, for example, 300°C or lower or 100 to 250°C and 1 to 180 minutes or 1 to 120 minutes.

### (Processing Step)

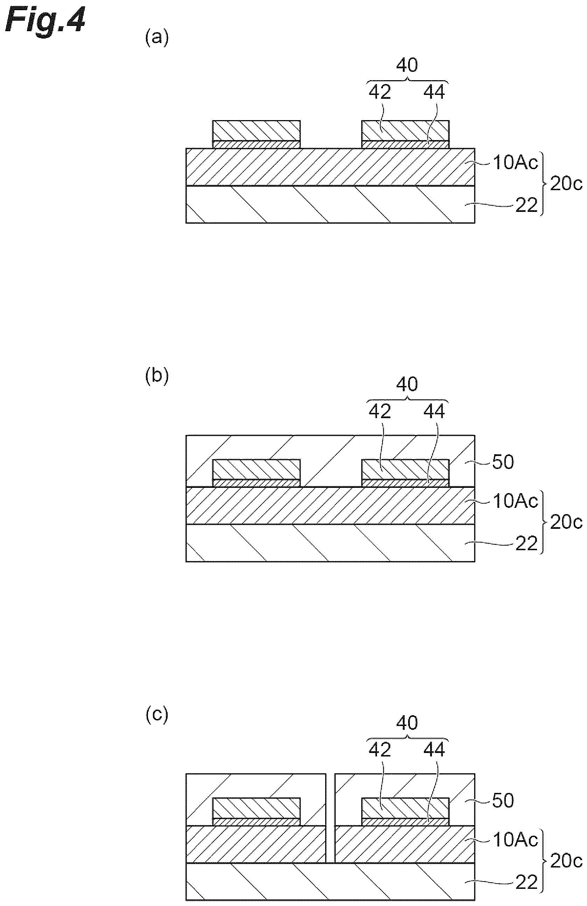

FIG. 4A, FIG. 4B, and FIG. 4C are schematic cross-sectional views illustrating an embodiment of the method for manufacturing a semiconductor device. In the processing step, the semiconductor member 40 temporarily fixed to the support member 22 is processed. FIG. 4A shows an example of processing including thickness reduction of a semiconductor substrate. Processing of the semiconductor member is not limited to this and can include, for example, thickness reduction of the semiconductor substrate, division (dicing) of the semiconductor member, formation of through electrodes (silicon through electrodes), etching treatment, plating reflow treatment, sputtering treatment, or combinations of these.

After the processing of the semiconductor member 40, as shown in FIG. 4B, a sealing layer 50 for sealing the processed semiconductor member 40 is formed. The sealing layer 50 can be formed using a sealing material that is usually used for the manufacture of semiconductor elements. For example, the sealing layer 50 may be formed using a thermosetting resin composition. Examples of the thermosetting resin composition used for the sealing layer 50 include epoxy resins such as a cresol novolac epoxy resin, a phenol novolac epoxy resin, a biphenyl diepoxy resin, and a naphthol novolac epoxy resin. The sealing layer 50 and the thermosetting resin composition for forming the sealing layer 50 may include a filler and/or additives such as a flame retardant.

The sealing layer 50 is formed using, for example, a solid material, a liquid material, a fine granular material, or a sealing film. In a case where a sealing film is used, a compression sealing molding machine, a vacuum lamination apparatus, and the like are used. For example, the sealing layer 50 can be formed by covering the semiconductor member 40 with a sealing film that has been thermally melted under the conditions of 40 to 180°C (or 60 to 150°C), 0.1 to 10 MPa (or 0.5 to 8 MPa), and 0.5 to 10 minutes, using these apparatuses. The thickness of the sealing film is adjusted such that the sealing layer 50 has a thickness equal to or greater than the thickness of the semiconductor member 40 after processing. The thickness of the sealing film may be 50 to 2000 µm, 70 to 1500 µm, or 100 to 1000 µm.

After the sealing layer 50 is formed, as shown in FIG. 4C, the sealing layer 50 and the temporary fixing material layer 10Ac may be divided into a plurality of portions, each of which includes one semiconductor member 40.

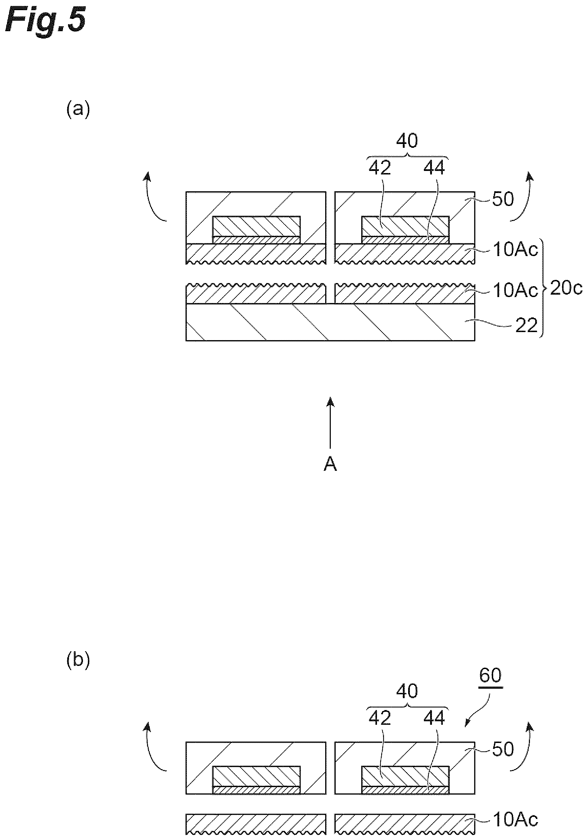

FIG. 5A and FIG. 5B are schematic cross-sectional views illustrating an embodiment of the method for manufacturing a semiconductor device. As shown in FIG. 5A, a laminated body for temporary fixing 20c is irradiated with light A from the support member 22 side to separate the semiconductor member 40 from the support member 22. The light A may be light including ultraviolet light, or may be light including wavelengths of 200 to 400 nm (near-ultraviolet light). By irradiating with light A, the component (A) in the temporary fixing material layer 10Ac absorbs light A, and then, molecular weight reduction of high-molecular weight components (melting of the cured product) may proceed as a result of, for example, cutting of the molecular chains of high-molecular weight components by thermal energy. Such a phenomenon serves as a main cause of the occurrence of cohesive peeling or the like of the temporary fixing material layer 10Ac, and the semiconductor member 40 can be easily separated from the support member 22. In order to separate the semiconductor member 40 from the support member 22, a slight stress may be applied to the semiconductor member 40 together with irradiation with light A.

Examples of a light source for the light A in the separation step include a low-pressure mercury lamp, a high-pressure mercury lamp, an ultrahigh-pressure mercury lamp, and a laser lamp. Among these, the light source for the light A may be a laser.

Examples of the laser include a solid laser such as a YAG laser; a liquid laser such as a dye laser; and a gas laser such as an excimer laser. Among these, the laser may be an excimer laser.

Examples of the excimer laser include an ArF excimer laser (oscillation wavelength: 193 nm), a KrF excimer laser (oscillation wavelength: 248 nm), an XeCl excimer laser (oscillation wavelength: 308 nm), and an XeF excimer laser (oscillation wavelength: 351 nm).

The conditions for laser irradiation include an applied voltage, a pulse width, an irradiation time, an irradiation distance (distance between the light source and the temporary fixing material layer), irradiation energy, and the like, and these can be arbitrarily set according to the number of times of irradiation, and the like. From the viewpoint of reducing damage to the semiconductor member 40, the conditions for laser irradiation the conditions for laser irradiation may be set to conditions for irradiation in which the semiconductor member 40 can be separated in a smaller number of times.

A portion of the temporary fixing material layer 10Ac (a portion of the cured curable resin layer) may adhere onto the separated semiconductor member 40 as residue. The adhered residue is removed as shown in FIG. 5B. The adhered residue may be removed by, for example, washing with a solvent, or may be detached by peeling. The solvent is not particularly limited; however, examples thereof include ethanol, methanol, toluene, xylene, acetone, methyl ethyl ketone, methyl isobutyl ketone, and hexane. For the removal of adhered residue, the semiconductor member 40 may be immersed in a solvent, or may be subjected to ultrasonic cleaning. The semiconductor member 40 may be heated at a low temperature of about 100°C or lower.

By the method described above as an example, a semiconductor element 60 including a processed semiconductor member 40 can be obtained. A semiconductor device can be manufactured by connecting the obtained semiconductor element 60 to another semiconductor element or a semiconductor element mounting substrate.

### [Composition for Temporary Fixing]

A composition for temporary fixing according to an embodiment is used for temporarily fixing a semiconductor member and a support member. The composition for temporary fixing contains an ultraviolet absorber having a hydroxyl group, a thermosetting resin having a functional group capable of reacting with the hydroxyl group, and a thermoplastic resin. The thermosetting resin may be an epoxy resin. The thermoplastic resin may be a hydrocarbon resin.

Preferred aspects of each of the components (component (A), component (B), component (C), other components, and the like) in the composition for temporary fixing are similar to preferred embodiments of each of the components (component (A), component (B), component (C), other components, and the like) in the film for temporary fixing 10. Therefore, any overlapping description will not be repeated herein. Furthermore, the content of each of the components in the composition for temporary fixing may be similar to the content of each of the components in the film for temporary fixing.

### Examples

Hereinafter, the present disclosure will be described more specifically by way of Examples. However, the present disclosure is not intended to be limited to these Examples.

### [Production and Evaluation of Film for Temporary Fixing]

(Examples 1-1 to 1-3 and Comparative Examples 1-1 and 1-2)
(Examples 2-1 to 2-6)

### <Production of Film for Temporary Fixing>

For the production of a film for temporary fixing, the following materials were used.

### Component (A): Ultraviolet Absorber Having a Hydroxyl Group

(A-1)
   2,4,6-Tris(2-hydroxy-4-hexyloxy-3-methylphenyl)-1,3,5-triazine (triazine-based ultraviolet absorber, trade name: LA-F70, manufactured by ADEKA Corporation)
(A-2)
   2-(2H-benzotriazol-2-yl)-4,6-bis(1-methyl-1-phenylethyl)phenol (benzotriazole-based ultraviolet absorber, trade name: LA-24, manufactured by ADEKA Corporation)

### Component (B): Thermosetting Resin Having a Functional Group Capable of Reacting with a Hydroxyl Group

(B-1) Dicyclopentadiene type epoxy resin (trade name: HP7200H, manufactured by DIC Corporation), component (B-1) was used as a cyclohexanone solution having a concentration of 50% by mass.

### Component (C): Thermoplastic Resin

(C-1) Maleic anhydride-modified styrene-ethylene-butylene-styrene block copolymer (trade name: FG1924GT, manufactured by KRATON CORPORATION, styrene content: 13% by mass), component (C-1) was used as a xylene solution having a concentration of 25% by mass.

(C-2) Maleic anhydride-modified styrene-ethylene-butylene-styrene block copolymer (trade name: FG1901GT, manufactured by KRATON CORPORATION, styrene content: 30% by mass), component (C-2) was used as a xylene solution having a concentration of 25% by mass.

### Other components

### (D) Curing accelerator

(D-1) Imidazole derivative (trade name: 2PZ-CN, manufactured by SHIKOKU CHEMICALS CORPORATION), component (D-1) was used as a cyclohexanone solution having a concentration of 10% by mass.

### (E) Antioxidant

(E-1) Hindered phenol derivative (trade name: AO-60, manufactured by ADEKA Corporation), used as a cyclohexanone solution having a concentration of 10% by mass.

The materials shown in Table 1 and Table 2 were used in the amounts of parts by mass indicated in Table 1 and Table 2 (numerical values in Table 1 and Table 2 mean non-volatile contents). These were mixed with 302.4 parts by mass of toluene and 4.5 parts by mass of cyclohexanone as solvents, and a varnish of a composition for temporary fixing was obtained. The obtained varnish of the composition for temporary fixing was applied on a release-treated surface of a support film (PUREX A31B (trade name, light peeling type, polyethylene terephthalate (PET) film, Toyobo Film Solution, Ltd., thickness: 38 µm)), using a precision coating machine. The coating film was heated at 100°C for 10 minutes to remove the solvent, and films for temporary fixing of Examples 1-1 to 1-9 and Comparative Examples 1-1 and 1-2 having the thicknesses indicated in Table 1 and Table 2 were obtained. A protective film (PUREX A70J (trade name, heavy peeling type, PET film, Toyobo Film Solution, Ltd., thickness: 38 µm)) was stuck to a surface of the obtained film for temporary fixing, the surface being on the opposite side of the support film, in a direction in which the release-treated surface of the protective film was in contact with the film for temporary fixing.

### <Evaluation of Film for Temporary Fixing>

The transmittance for a wavelength of 308 nm or a wavelength of 355 nm was measured using the films for temporary fixing of Examples 1-1 to 1-3, Comparative Examples 1-1 and 1-2, and Examples 2-1 to 2-6. A film for temporary fixing was cut into a square that measured 5 cm on each side to obtain a sample for measurement. Using an ultraviolet-visible-near-infrared spectrophotometer, SolidSpec-3700 (Shimadzu Corporation) as a measuring apparatus, the proportion of the intensity of transmitted light with respect to the intensity of incident light obtained when light having a wavelength of 308 nm or a wavelength of 355 nm was incident on one principal surface side of the sample for measurement, was calculated as the transmittance. The results are shown in Table 1 and Table 2.

**Table 1**

| | | | Unit | Comp. Exam. 1-1 | Comp. Exam. 1-2 | Exam. 1-1 | Exam. 1-2 | Exam. 1-3 |
|---|---|---|---|---|---|---|---|---|
| Material | (A) | (A-1) | Parts by mass | - | - | 2 | 5 | 10 |
| | | (A-2) | Parts by mass | - | - | - | - | - |
| | (B) | (B-1) | Parts by mass | 30 | 30 | 30 | 30 | 30 |
| | (C) | (C-1) | Parts by mass | 35 | 35 | 35 | 35 | 35 |
| | | (C-2) | Parts by mass | 35 | 35 | 35 | 35 | 35 |
| | (D) | (D-1) | Parts by mass | 0.5 | 0.5 | 0.5 | 0.5 | 0.5 |
| | (E) | (E-1) | Parts by mass | 0.8 | 0.8 | 0.8 | 0.8 | 0.8 |
| Film thickness | | | µm | 10 | 50 | 50 | 50 | 50 |
| Transmittance | | 308 nm | % | 43 | 1.5 | 1.0 | 0 | 0 |
| | | 355 nm | % | 76 | 21 | 2.0 | 0 | 0 |

**Table 2**

| | | | Unit | Exam. 2-1 | Exam. 2-2 | Exam. 2-3 | Exam. 2-4 | Exam. 2-5 | Exam. 2-6 |
|---|---|---|---|---|---|---|---|---|---|
| Material | (A) | (A-1) | Parts by mass | 2 | 5 | 10 | - | - | - |
| | | (A-2) | Parts by mass | - | - | - | 2 | 10 | 30 |
| | (B) | (B-1) | Parts by mass | 30 | 30 | 30 | 30 | 30 | 30 |
| | (C) | (C-1) | Parts by mass | 35 | 35 | 35 | 35 | 35 | 35 |
| | | (C-2) | Parts by mass | 35 | 35 | 35 | 35 | 35 | 35 |
| | (D) | (D-1) | Parts by mass | 0.5 | 0.5 | 0.5 | 0.5 | 0.5 | 0.5 |
| | (E) | (E-1) | Parts by mass | 0.8 | 0.8 | 0.8 | 0.8 | 0.8 | 0.8 |
| Film thickness | | | µm | 10 | 10 | 10 | 10 | 10 | 10 |
| Transmittance | | 308 nm | % | 1.0 | 1.0 | 0 | 6.0 | 0 | 0 |
| | | 355 nm | % | 34 | 13 | 0 | 49 | 44 | 0 |

### [Production of Laminated Body for Temporary Fixing and Laminated Body for Testing (i)]

### (Examples 3-1 to 3-3 and Comparative Examples 3-1 and 3-2)

### <Production of Laminated Body for Temporary Fixing>

A laminated body for temporary fixing was produced using each of the films for temporary fixing of Examples 1-1 and 1-3 and Comparative Examples 1-1 and 1-2. Laminated bodies for temporary fixing of Examples 3-1 to 3-3 and Comparative Examples 3-1 and 3-2 were produced by peeling the support film from the film for temporary fixing, and laminating the film for temporary fixing on a glass substrate (trade name: EAGLE XG, manufactured by CORNING, Inc., size: 20 mm × 20 mm, thickness: 0.7 mm) as a support member using a vacuum pressure type laminator under the conditions of a pressure of 0.5 MPa, a temperature of 100°C, and a pressurization time of 60 seconds.

### <Production of Laminated Body for Testing>

Next, the protective film on the side of the temporary fixing material layer formed from the film for temporary fixing of each of the laminated bodies for temporary fixing of Examples 3-1 to 3-3 and Comparative Examples 3-1 and 3-2 was peeled, and a silicon wafer (size: 20 mm × 20 mm, thickness: 150 µm) as a semiconductor member was laminated on the temporary fixing material layer using a vacuum pressure type laminator under the conditions of a pressure of 0.5 MPa, a temperature of 100°C, and a pressurization time of 60 seconds. Thereafter, the temporary fixing material layer was cured by heating at 200°C for 1 hour to produce each of the laminated bodies for testing of Examples 3-1 to 3-3 and Comparative Examples 3-1 and 3-2, which had a semiconductor member temporarily fixed to a support member.

### [Production of Laminated Body for Temporary Fixing and Laminated Body for Testing (ii)]

### (Examples 4-1 to 4-8)

### <Production of Curable Resin Film>

For the production of curable resin films, the following materials were used.

### Component (B): Thermosetting Resin Having a Functional Group Capable of Reacting with a Hydroxyl Group

(B-1) Dicyclopentadiene type epoxy resin (trade name: HP7200H, manufactured by DIC Corporation), component (B-1) was used as a cyclohexanone solution having a concentration of 50% by mass.

(B-2) o-Cresol-novolac type epoxy resin (trade name: N-500P-10, manufactured by DIC Corporation), component (B-2) was used as a cyclohexanone solution having a concentration of 50% by mass.

(B-3) Bisphenol F type liquid epoxy resin (trade name: YL983U, manufactured by Mitsubishi Chemical Corporation), component (B-3) was used as it was without diluting.

### Component (b): Curing Agent for an Epoxy Resin

(b-1) Phenol novolac resin (trade name: MEH-7800, manufactured by Meiwa Plastic Industries, Ltd.), component (b-1) was used as a cyclohexanone solution having a concentration of 50% by mass.

### Component (C): Thermoplastic Resin

(C-1) Maleic anhydride-modified styrene-ethylene-butylene-styrene block copolymer (trade name: FG1924GT, manufactured by KRATON CORPORATION, styrene content: 13% by mass), component (C-1) was used as a xylene solution having a concentration of 25% by mass.

(C-2) Maleic anhydride-modified styrene-ethylene-butylene-styrene block copolymer (trade name: FG1901GT, manufactured by KRATON CORPORATION, styrene content: 30% by mass), component (C-2) was used as a xylene solution having a concentration of 25% by mass.

(C-3) Biphenylfluorene type phenoxy resin (trade name: FX293, manufactured by NIPPON STEEL Chemical & Material Co., Ltd.), component (C-3) was used as a cyclohexanone solution having a concentration of 15% by mass.

(C-4) Acrylic rubber (trade name: HTR-860-P3, manufactured by Nagase ChemteX Corporation), component (C-4) was used as a methyl ethyl ketone solution having a concentration of 12% by mass.

### (D) Curing accelerator

(D-1) Imidazole derivative (trade name: 2PZ-CN, manufactured by SHIKOKU CHEMICALS CORPORATION), component (D-1) was used as a cyclohexanone solution having a concentration of 10% by mass.

### (E) Antioxidant

(E-1) Hindered phenol derivative (trade name: AO-60, manufactured by ADEKA Corporation), used as a cyclohexanone solution having a concentration of 10% by mass.

The materials shown in Table 3 were used in the amounts of parts by mass indicated in Table 3 (numerical values in Table 3 mean non-volatile contents). These were mixed with 302.4 parts by mass of toluene and 4.5 parts by mass of cyclohexanone as solvents, and a varnish of a composition for temporary fixing was obtained. The obtained varnish of the composition for temporary fixing was applied on a release-treated surface of a support film (PUREX A31B (trade name, light peeling type, polyethylene terephthalate (PET) film, Toyobo Film Solution, Ltd., thickness: 38 µm)), using a precision coating machine. The coating film was heated at 100°C for 10 minutes to remove the solvent, and a curable resin film of Production Example 1-3 having a thickness of 30 µm was obtained. A protective film (PUREX A70J (trade name, heavy peeling type, PET film, Toyobo Film Solution, Ltd., thickness: 38 µm)) was stuck to a surface of the obtained curable resin film, the surface being on the opposite side of the support film, in a direction in which the release-treated surface of the protective film was in contact with the curable resin film.

**Table 3**

| | | | Unit | Prod. Exam. 1 | Prod. Exam. 2 | Prod. Exam. 3 |
|---|---|---|---|---|---|---|
| Material | (B) | (B-1) | Parts by mass | 30 | 30 | - |
| | | (B-2) | Parts by mass | - | - | 10 |
| | | (B-3) | Parts by mass | - | - | 20 |
| | (b) | (b-1) | Parts by mass | - | - | 30 |
| | (C) | (C-1) | Parts by mass | 35 | - | - |
| | | (C-2) | Parts by mass | 35 | - | - |
| | | (C-3) | Parts by mass | - | 70 | - |
| | | (C-4) | Parts by mass | - | - | 40 |
| | (D) | (D-1) | Parts by mass | 0.5 | 1.0 | 0.5 |
| | (E) | (E-1) | Parts by mass | 0.8 | - | - |
| Film thickness | | | µm | 30 | 30 | 30 |

### <Production of Laminated Body for Temporary Fixing>

Laminated bodies for temporary fixing having the configurations shown in Table 5 were produced using the films for temporary fixing of Examples 2-1 to 2-6 and the curable resin film of Production Example 1-3. The support film was peeled from each of the films, and the exposed surfaces were stuck together using a pressure-type roll laminator under the conditions of a pressure of 0.2 MPa, a temperature of 100°C, and a speed of 0.2 m/min to obtain a two-layered film. Next, the protective film on the film for temporary fixing side of the two-layered film was peeled, and the two-layered film was laminated in the same manner as in <Production of Laminated body for Temporary Fixing> of the above-described section [Production of Laminated Body for Temporary Fixing and Laminated Body for Testing (i)], in a direction in which the peeled surface was in contact with the support member, to produce laminated bodies for temporary fixing of Examples 4-1 to 4-8, each of which included a support member, a temporary fixing material layer, and a curable resin layer in this order.

### <Production of Laminated Body for Testing>

Next, a semiconductor member was laminated on the curable resin layer in the same manner as in <Production of Laminated Body for Testing> of the above-described section [Production of Laminated Body for Temporary Fixing and Laminated Body for Testing (i)], and the temporary fixing material layer and the curable resin layer were cured under similar conditions, to produce laminated bodies for testing of Examples 4-1 to 4-8.

### [Production of Laminated Body for Temporary Fixing and Laminated Body for Testing (iii)]

### (Examples 5-1 to 5-3)

### <Preparation of First Curable Resin Film and Second Curable Resin Film>

As a first curable resin film and a second curable resin film, the first curable resin film of Production Example 1 was prepared.

### <Production of Laminated body for temporary fixing>

Laminated bodies for temporary fixing having the configurations shown in Table 6 were produced using the films for temporary fixing of Examples 2-1 to 2-3, the first curable resin film, and the second curable resin film. First, a two-layered film composed of each of the films for temporary fixing of Examples 2-1 to 2-3 and the above-described first curable resin film was obtained in the same manner as in <Production of Laminated Body for Temporary Fixing> of the above-described section [Production of Laminated Body for Temporary Fixing and Laminated Body for Testing (ii)]. Next, the protective film on the temporary fixing material layer side formed from the film for temporary fixing of Example 1-3 and the support film of the second curable resin film of the two-layered film were peeled, and the exposed surfaces were stuck together using a pressure-type roll laminator under the conditions of a pressure of 0.2 MPa, a temperature of 100°C, and a speed of 0.2 m/min to obtain a three-layered film. Next, the protective film on the first curable resin film side of the three-layered film was peeled, and the three-layered film was laminated in the same manner as in <Production of Laminated Body for Temporary Fixing> of the above-described section [Production of Laminated Body for Temporary Fixing and Laminate for Testing (i)], in a direction in which the peeled surface was in contact with the support member, to produce laminated bodies for temporary fixing of Examples 5-1 to 5-3, each of which included a support member, a first curable resin layer, a temporary fixing material layer, and a second curable resin layer in this order.

### <Production of Laminated Body for Testing>

Next, a semiconductor member was laminated on the second curable resin layer in the same manner as in <Production of Laminated Body for Testing> of the above-described section [Production of Laminated Body for Temporary Fixing and Laminated Body for Testing (i)], and the temporary fixing material layer, the first curable resin layer, and the second curable resin layer were cured under similar conditions, to produce laminated bodies for testing of Examples 5-1 to 5-3.

### [Evaluation of Laminated Body for Testing]

### <Evaluation of Separability>

Each of the laminated bodies for testing was irradiated with ultraviolet laser light under the conditions of a wavelength of 355 nm or a wavelength of 308 nm, and separability at the time of separating the semiconductor member from the support member was evaluated.

### · Testing Conditions for Wavelength of 355 nm

Each of the laminated bodies for testing was irradiated with ultraviolet laser light using a UV laser marker (PU-L3A manufactured by Laser Works, Inc., beam diameter: 20 µm), under the conditions of a wavelength of 355 nm. Light irradiation using a laser was carried out from the support member side (glass substrate) of the laminated body for testing, and the irradiation time was set to 5 minutes per 5 cm square. Regarding the evaluation of separability, a case in which after light irradiation using a laser, the silicon wafer was separated from the glass substrate by applying an external force, was evaluated as having excellent separability and was rated as "A"; and a case in which the silicon wafer was not separated from the glass substrate even when an external force was applied, was rated as "B". The results are shown in Table 4, Table 5, and Table 6.

### · Testing Conditions for Wavelength of 308 nm

Each of the laminated bodies for testing was irradiated, using a KrF excimer laser, with ultraviolet pulsed laser light having a wavelength of 308 nm, a pulse energy of 1300 mJ/cm², and a repetition frequency of 30 kHz. IPEX-848 manufactured by Optec SpA was used as the KrF excimer laser, and light irradiation using a laser was carried out over the entire surface of the support member from the support member (glass substrate) side of the laminated body for testing at a scan speed of 18.5 mm/s. Regarding the evaluation of separability, a case in which after light irradiation using a laser, the silicon wafer was separated from the glass substrate by applying an external force, was evaluated as having excellent separability and was rated as "A"; and a case in which the silicon wafer was not separated from the glass substrate even when an external force was applied, was rated as "B". The results are shown in Table 4, Table 5, and Table 6. When the rating of separability was "A", the cumulative amount of light (mJ/cm²) was also recorded.

### <Evaluation of Removability of Residue>

After the above-described evaluation of separability was performed, the removability of the residue adhering to the support member (glass substrate) side (mainly, the residue of the cured temporary fixing material layer side and the residue of the cured first curable resin layer), and the residue adhering to the semiconductor member (silicon wafer) side (mainly, the residue of the cured temporary fixing material layer, the residue of the cured curable resin layer, and the residue of the cured second curable resin layer) was evaluated. The residue adhering to the support member side was wiped off with a rag, and a case in which removal of the residue was very easy was rated as "A"; a case in which removal was easy was rated as "B"; a case in which removal was possible was rated as "C"; and a case in which removal was insufficient was rated as "D". The results are shown in Table 4, Table 5, and Table 6. Furthermore, the residue adhering to the semiconductor member side was torn off (peeled off), and a case in which removal of the residue was very easy was rated as "A"; a case in which removal was easy was rated as "B"; a case in which removal was possible was rated as "C"; and a case in which removal was insufficient was rated as "D". The results are shown in Table 4, Table 5, and Table 6.

**Table 4**

| | | Comp. Exam. 3-1 | Comp. Exam. 3-2 | Exam. 3-1 | Exam. 3-2 | Exam. 3-3 |
|---|---|---|---|---|---|---|
| Layer configuration of laminated body for temporary fixing | Temporary fixing material layer | Comp. Exam. 1-1 | Comp. Exam. 1-2 | Exam. 1-1 | Exam. 1-2 | Exam. 1-3 |
| Evaluation of separability (wavelength 355 nm) | Separability | B | B | A | A | A |
| Evaluation of residue removability (wavelength 355 nm) | Support member side | - | - | B | D | D |
| | Semiconductor member side | - | - | C | C | C |

**Table 5**

| | | Exam. 4-1 | Exam. 4-2 | Exam. 4-3 | Exam. 4-4 | Exam. 4-5 | Exam. 4-6 | Exam. 4-7 | Exam. 4-8 |
|---|---|---|---|---|---|---|---|---|---|
| Layer configuration of laminated body for temporary fixing | Curable resin layer | Prod. Exam. 1 | Prod. Exam. 1 | Prod. Exam. 1 | Prod. Exam. 1 | Prod. Exam. 1 | Prod. Exam. 1 | Prod. Exam. 2 | Prod. Exam. 3 |
| | Temporary fixing material layer | Exam. 2-1 | Exam. 2-2 | Exam. 2-3 | Exam. 2-4 | Exam. 2-5 | Exam. 2-6 | Exam. 2-3 | Exam. 2-3 |
| Evaluation of separability (wavelength 355 nm) | Separability | A | A | A | A | A | A | A | A |
| Evaluation of residue removability (wavelength 355 nm) | Support member side | B | B | B | C | C | C | C | B |
| | Semiconductor member side | B | B | B | D | D | D | A | A |
| Evaluation of separability (wavelength 308 nm) | Separability | A | A | A | Not performed | Not performed | Not performed | Not performed | Not performed |
| | Cumulative amount of light (mJ/cm²) | 1500 | 1500 | 1500 | | | | | |
| Evaluation of residue removability (wavelength 308 nm) | Support member side | A | B | B | | | | | |
| | Semiconductor member side | A | B | C | | | | | |

**Table 6**

| | | Exam. 5-1 | Exam. 5-2 | Exam. 5-3 |
|---|---|---|---|---|
| Layer configuration of laminated body for temporary fixing | First curable resin layer | Prod. Exam. 1 | Prod. Exam. 1 | Prod. Exam. 1 |
| | Temporary fixing material layer | Exam. 2-1 | Exam. 2-2 | Exam. 2-3 |
| | Second curable resin layer | Prod. Exam. 1 | Prod. Exam. 1 | Prod. Exam. 1 |
| Evaluation of separability (wavelength 355 nm) | Separability | A | A | A |
| Evaluation of residue removability (wavelength 355 nm) | Support member side | A | A | B |
| | Semiconductor member side | A | B | C |

As shown in Table 4, Table 5, and Table 6, the laminated bodies for temporary fixing (laminated bodies for testing) including a temporary fixing material layer formed from the films for temporary fixing of Examples 1-1 to 1-3 and Examples 2-1 to 2-6 were excellent in terms of separability. From these results, it was verified that the film for temporary fixing of the present disclosure is capable of forming a temporary fixing material layer that can separate a semiconductor member and a support member by irradiation with light including ultraviolet light.

### Reference Signs List

10: film for temporary fixing, 10A, 10Ac: temporary fixing material layer, 12: curable resin layer, 14: first curable resin layer, 16: second curable resin layer, 20, 70, 80, 20c: laminated body for temporary fixing, 22: support member, 30: laminated body, 40: semiconductor member, 42: semiconductor substrate, 44: rewiring layer, 50: sealing layer, 60: semiconductor element.

## Claims

1. A film for temporary fixing, used for temporarily fixing a semiconductor member and a support member,
the film for temporary fixing comprising:
an ultraviolet absorber having a hydroxyl group;
a thermosetting resin having a functional group capable of reacting with the hydroxyl group; and
a thermoplastic resin.

2. The film for temporary fixing according to claim 1, wherein the thermosetting resin is an epoxy resin.

3. The film for temporary fixing according to claim 1, wherein the thermoplastic resin is a hydrocarbon resin.

4. The film for temporary fixing according to claim 1, wherein a transmittance at at least one wavelength between a wavelength of 308 nm and a wavelength of 355 nm is 15% or less.

5. A laminated body for temporary fixing, comprising:
a support member; and
a temporary fixing material layer provided on the support member and formed from the film for temporary fixing according to claim 1.

6. The laminated body for temporary fixing according to claim 5, further comprising a curable resin layer provided on the temporary fixing material layer.

7. A laminated body for temporary fixing, comprising, in the following order:
a support member;
a first curable resin layer; and
a temporary fixing material layer formed from the film for temporary fixing according to claim 1.

8. The laminated body for temporary fixing according to claim 7, further comprising a second curable resin layer provided on the temporary fixing material layer.

9. A method for manufacturing a semiconductor device, the method comprising:
preparing the laminated body for temporary fixing according to any one of claims 5 to 8;
temporarily fixing a semiconductor member to the support member, with the temporary fixing material layer interposed therebetween;
processing the semiconductor member temporarily fixed to the support member; and
irradiating the temporary fixing material layer of the laminated body for temporary fixing with light including ultraviolet light from the support member side, to separate the semiconductor member from the support member.

10. A composition for temporary fixing, used for temporarily fixing a semiconductor member and a support member,
the composition for temporary fixing comprising:
an ultraviolet absorber having a hydroxyl group;
a thermosetting resin having a functional group capable of reacting with the hydroxyl group; and
a thermoplastic resin.

11. The composition for temporary fixing according to claim 10, wherein the thermosetting resin is an epoxy resin.

12. The composition for temporary fixing according to claim 10, wherein the thermoplastic resin is a hydrocarbon resin.
